(19)

**Europäisches Patentamt**
**European Patent Office**
**Office européen des brevets**

(11) **EP 4 462 137 A1**

(12) **EUROPEAN PATENT APPLICATION**
published in accordance with Art. 153(4) EPC

(43) Date of publication:
**13.11.2024  Bulletin 2024/46**

(51) International Patent Classification (IPC):
***G01R 31/36*** (2020.01)  ***H02J 7/00*** (2006.01)

(21) Application number: **22930227.8**

(52) Cooperative Patent Classification (CPC):
**G01R 31/36; H02J 7/00**

(22) Date of filing: **07.03.2022**

(86) International application number:
**PCT/CN2022/079623**

(87) International publication number:
**WO 2023/168581 (14.09.2023 Gazette 2023/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **FAN, Tuanbao**
**Shenzhen, Guangdong 518129 (CN)**

• **WANG, Yang**
**Shenzhen, Guangdong 518129 (CN)**
• **SHI, Xiaoshan**
**Shenzhen, Guangdong 518129 (CN)**
• **JIANG, Yuexing**
**Shenzhen, Guangdong 518129 (CN)**
• **JIANG, Mingfeng**
**Shenzhen, Guangdong 518129 (CN)**
• **HU, Zhangrong**
**Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **IMPEDANCE DETECTION DEVICE FOR BATTERY**

(57)     A battery impedance detection apparatus is provided, and the apparatus includes: a first processing module (501), configured to: perform first code transformation on a first signal based on a preset code, to obtain an excitation signal, and apply the excitation signal to a battery, where the first signal is an original signal used to generate the excitation signal; a sampler (502), coupled to the battery, and configured to sample a voltage of the battery after the excitation signal is applied to the battery, to obtain a sampled voltage signal; and a second processing module (503), configured to: perform second code transformation on the sampled voltage signal based on the preset code, to obtain a first voltage signal; perform the second code transformation on a current signal of the battery based on the preset code, to obtain a first current signal; and determine, based on the first voltage signal and the first current signal, impedance corresponding to the battery. According to the foregoing method, EIS detection can be implemented when the battery is in a charging state or the battery is in a load discharging state.

FIG. 8

**EP 4 462 137 A1**

**Description**

**TECHNICAL FIELD**

Embodiments of this application relate to the battery field, and in particular, to a battery impedance detection apparatus.

**BACKGROUND**

As a charging speed and battery energy density increase, a battery safety risk continuously raises. Especially for a ternary lithium battery, initial oxygen generated during temperature rise is very likely to cause explosion, which poses a serious threat to personal and property safety of a user. Therefore, detection and prevention in advance through technical means before spontaneous combustion of the battery becomes a key to safe use of a high energy density lithium-ion battery.

Electrochemical impedance spectroscopy (electrochemical impedance spectroscopy, EIS) is an effective method for detecting battery safety, includes abundant basic electrochemical information and physical process information of a battery, can be used to detect exceptions such as short circuit, lithium metal deposition, overtemperature, and swelling in the battery, and is an effective method for detecting and preventing a battery fault in advance.

However, EIS detection is a static detection method, that is, detection can be performed only when there is no interference current in the battery. Therefore, a method for implementing EIS detection in a scenario in which load interference exists in the battery is required.

**SUMMARY**

This application provides a battery impedance detection apparatus, to implement EIS detection in a scenario in which load interference exists in a battery.

According to a first aspect, this application provides a battery impedance detection apparatus, where the apparatus includes: a first processing module, configured to: perform first code transformation on a first signal based on a preset code, to obtain an excitation signal, and apply the excitation signal to a battery, where the first signal is an original signal used to generate the excitation signal; a sampler, coupled to the battery, and configured to sample a voltage of the battery after the excitation signal is applied to the battery, to obtain a sampled voltage signal; and a second processing module, configured to: perform second code transformation on the sampled voltage signal based on the preset code, to obtain a first voltage signal; perform the second code transformation on a current signal of the battery based on the preset code, to obtain a first current signal; and determine, based on the first voltage signal and the first current signal, impedance corresponding to the battery.

According to the foregoing method, by using the first code transformation and the second code transformation, an interference signal spectrum can be eliminated from a test frequency of EIS detection, and EIS detection can be implemented when the battery is in a charging state or the battery is in a load discharging state. In addition, the foregoing method has characteristics of strong anti-interference and high precision.

In a possible design, the first processing module includes a first code transformation module, configured to multiply the preset code by the first signal, to obtain the excitation signal.

The first code transformation is implemented in the foregoing manner to obtain the excitation signal. The solution is simple and easy to implement. In addition, the excitation signal may be obtained in another manner. This is not limited in this application. A frequency domain waveform of the excitation signal obtained through the first code transformation is different from a frequency domain waveform of the first signal.

In a possible design, the first processing module includes: a digital-to-analog converter DAC, configured to perform digital-to-analog conversion on the excitation signal to obtain an analog signal; and a current generator, configured to: generate an excitation current based on the analog signal, and apply the excitation current to the battery.

According to the foregoing design, the excitation signal may be converted into the excitation current, and the excitation current may be applied to a positive electrode or a negative electrode of the battery.

In a possible design, the sampler is further configured to sample a current of the battery, to obtain a current signal; or the current signal is determined through calculation based on the excitation signal.

According to the foregoing design, the current signal may be obtained in a plurality of manners.

In a possible design, the second processing module includes a second code transformation module, configured to: multiply the preset code by the sampled voltage signal, to obtain the first voltage signal, and multiply the preset code by the current signal, to obtain the first current signal.

The second code transformation is implemented in the foregoing manner to obtain the first voltage signal and the first current signal. The solution is simple and easy to implement.

In a possible design, a product of the preset code and the preset code is an all-1 sequence.

In a possible design, the preset code is a sequence that includes +1 and -1.

In a possible design, the preset code is a periodic sequence, and the sampler is further configured to: before the first processing module applies the excitation signal to the battery, sample the voltage of the battery, to obtain an interference voltage signal; and the second processing module is further configured to determine a periodicity of the preset code based on the sampled interference voltage signal.

In a possible design, the preset code is a non-periodic sequence. In this case, the periodicity of the preset code does not need to be determined.

According to a second aspect, this application provides a battery impedance detection apparatus. The apparatus includes:

a processor, configured to: perform first code transformation on a first signal based on a preset code, to obtain an excitation signal, and apply the excitation signal to a battery, where the first signal is an original signal used to generate the excitation signal; and a sampler, coupled to the battery, and configured to sample a voltage of the battery after the excitation signal is applied to the battery, to obtain a sampled voltage signal, where the processor is further configured to: perform second code transformation on the sampled voltage signal based on the preset code, to obtain a first voltage signal; perform the second code transformation on a current signal of the battery based on the preset code, to obtain a first current signal; and determine, based on the first voltage signal and the first current signal, impedance corresponding to the battery.

In a possible design, the processor is configured to: when performing the first code transformation on the first signal based on the preset code, to obtain the excitation signal, multiply the preset code by the first signal, to obtain the excitation signal.

In a possible design, the processor is configured to: when applying the excitation signal to the battery, perform digital-to-analog conversion on the excitation signal, to obtain an analog signal, generate an excitation current based on the analog signal, and apply the excitation current to the battery.

In a possible design, the sampler is further configured to sample a current of the battery, to obtain a current signal; or the current signal is determined through calculation based on the excitation signal.

In a possible design, the processor is further configured to: when performing the second code transformation on the sampled voltage signal based on the preset code, to obtain the first voltage signal, and performing the second code transformation on the current signal of the battery based on the preset code, to obtain the first current signal, multiply the preset code by the sampled voltage signal, to obtain the first voltage signal, and multiply the preset code by the current signal, to obtain the first current signal.

In a possible design, a product of the preset code and the preset code is an all-1 sequence.

In a possible design, the preset code is a sequence that includes +1 and -1.

In a possible design, the preset code is a periodic sequence, and the sampler is further configured to: before the first processing module applies the excitation signal to the battery, sample the voltage of the battery, to obtain an interference voltage signal; and the processor is further configured to determine a periodicity of the preset code based on the sampled interference voltage signal.

In a possible design, the preset code is a non-periodic sequence. In this case, the periodicity of the preset code does not need to be determined.

According to a third aspect, this application provides an electronic system. The system includes the apparatus according to the first aspect or the apparatus according to the second aspect, and a battery.

According to a fourth aspect, this application provides a battery impedance detection method, where the method includes: performing first code transformation on a first signal based on a preset code, to obtain an excitation signal, and applying the excitation signal to a battery, where the first signal is an original signal used to generate the excitation signal; sampling a voltage of the battery by using a sampler after the excitation signal is applied to the battery, to obtain a sampled voltage signal; performing second code transformation on the sampled voltage signal based on the preset code, to obtain a first voltage signal; performing the second code transformation on a current signal of the battery based on the preset code, to obtain a first current signal; and determining, based on the first voltage signal and the first current signal, impedance corresponding to the battery.

In a possible design, when the first code transformation is performed on the first signal based on the preset code, to obtain the excitation signal, the preset code is multiplied by the first signal, to obtain the excitation signal.

In a possible design, when the excitation signal is applied to the battery, digital-to-analog conversion is performed on the excitation signal to obtain an analog signal, an excitation current is generated based on the analog signal, and the excitation current is applied to the battery.

In a possible design, a current of the battery is sampled by using a sampler, to obtain the current signal; or the current signal is determined through calculation based on the excitation signal.

In a possible design, when performing the second code transformation on the sampled voltage signal based on the preset code, to obtain the first voltage signal, and performing the second code transformation on the current signal of the battery based on the preset code, to obtain the first current signal, the preset code is multiplied by the sampled voltage signal, to obtain the first voltage signal, and the preset code is multiplied by the current signal, to obtain the first current signal.

In a possible design, a product of the preset code and the preset code is an all-1 sequence.

In a possible design, the preset code is a sequence that includes +1 and -1.

In a possible design, the preset code is a periodic sequence, and before the excitation signal is applied to the battery, the voltage of the battery is sampled by using the sampler, to obtain an interference voltage signal; and a periodicity of the preset code is determined based on the sampled interference voltage signal.

In a possible design, the preset code is a non-periodic sequence. In this case, the periodicity of the preset code does not need to be determined.

According to a fifth aspect, this application further provides an apparatus. The apparatus may perform the method design in the fourth aspect. The apparatus may be a chip or a circuit that can perform the functions corresponding to the foregoing method, or a device including the chip or the circuit.

In a possible implementation, the apparatus includes: a memory, configured to store computer-executable program code; and a processor, where the processor is coupled to the memory. The program code stored in the memory includes instructions. When the processor executes the instructions, the apparatus or a device on which the apparatus is installed is enabled to perform the method in any one of the foregoing possible designs.

In a possible implementation, the apparatus may further include a communication interface. The communication interface may be a transceiver. Alternatively, if the apparatus is a chip or a circuit, the communication interface may be an input/output interface of the chip, for example, an input/output pin.

In a possible design, the apparatus includes corresponding function units, separately configured to implement the steps in the foregoing method. The function may be implemented by hardware, or may be implemented by executing corresponding software by hardware. The hardware or the software includes one or more units that correspond to the foregoing functions.

According to a sixth aspect, this application provides a computer-readable storage medium. The computer-readable storage medium stores a computer program. When the computer program is run on an apparatus, the method in any one of the possible designs of the fourth aspect is performed.

According to a seventh aspect, this application provides a computer program product. The computer program product includes a computer program, and when the computer program is run on an apparatus, the method in any one of the possible designs of the fourth aspect is performed.

## BRIEF DESCRIPTION OF DRAWINGS

FIG. 1 is a schematic diagram of EIS detection according to this application;

FIG. 2 is a schematic diagram of a VCCS circuit according to this application;

FIG. 3 is a schematic diagram in which EIS detection fails when a battery works online according to this application;

FIG. 4 is a schematic diagram of a structure of a terminal device according to this application;

FIG. 5 is a schematic diagram of a battery impedance detection apparatus according to this application;

FIG. 6 is a schematic diagram of components included in a first processing module 501 according to this application;

FIG. 7 is a schematic diagram of a time domain waveform and a frequency domain waveform of a preset code according to this application;

FIG. 8 is a schematic diagram of signals that pass through modules when impedance of a battery is detected according to this application;

FIG. 9 is a schematic diagram of a time domain waveform and a frequency domain waveform of an excitation signal according to this application;

FIG. 10 is a schematic diagram of components included in a second processing module 503 according to this application;

FIG. 11 is a schematic diagram of a time domain waveform and a frequency domain waveform of a first voltage signal according to this application; and

FIG. 12 is a schematic diagram of a time domain waveform and a frequency domain waveform of a first current signal according to this application.

## DESCRIPTION OF EMBODIMENTS

The following clearly and completely describes the technical solutions in embodiments of this application with reference to the accompanying drawings in embodiments of this application. It is clear that the described embodiments are merely some but not all of embodiments of this application. In the specification, claims, and accompanying drawings of this application, the terms "first", "second", corresponding term numbers, and the like are intended to distinguish between similar objects but do not necessarily indicate a specific order or sequence. It should be understood that the terms used in such a way are interchangeable in proper circumstances, and this is merely a discrimination manner that is used when objects having a same attribute are described in embodiments of this application. In addition, the terms "include", "have" and any other variants mean to cover the non-exclusive inclusion, so that a process, method, system, product, or device that includes a series of units is not necessarily limited to those units, but may include other units not expressly listed or inherent to such a process, method, system, product, or device.

In descriptions of this application, "/" means "or" unless otherwise specified. For example, A/B may indicate A or B. In this application, "and/or" describes only an association relationship for describing associated objects and indicates that three relationships may exist. For example, A and/or B may indicate the following three cases: Only A exists, both A and B exist, and only B exists. In addition, in the descriptions of this application, "at least one item" means one or more items, and "a plurality of items" means two or more items. "At least one item (piece) of the following" or a similar expression thereof means any combination of these items, including a singular item (piece) or any combination of plural items (pieces). For example, at least one item (piece) of a, b, or c may indicate a, b, c, a and b, a and c, b and c, or a, b, and c, where a, b, and c may be in a singular form or a plural form.

For ease of understanding of embodiments of this application, the following briefly describes EIS detection.

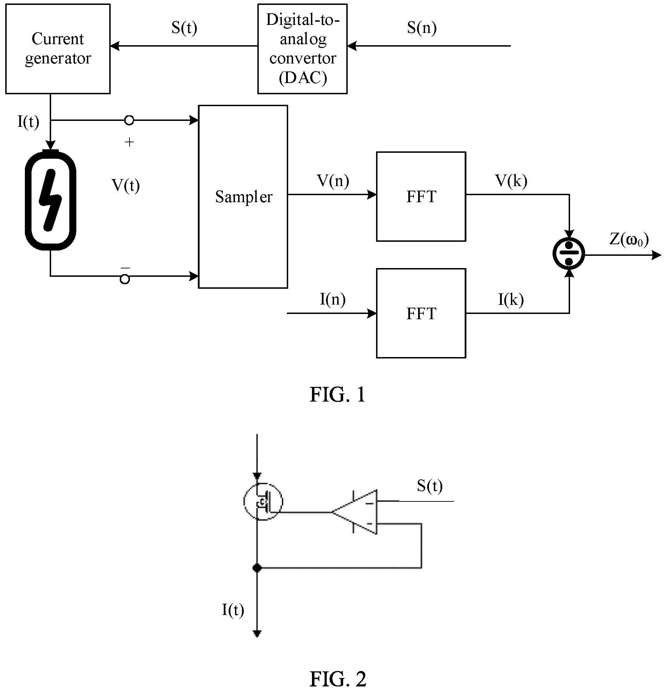

As shown in FIG. 1, for an excitation signal S(n), for example, $S(n)=A*\sin(2\pi f_0 n/f_s)$, an analog excitation signal S(t) corresponding to S(n) is first generated through digital-to-analog conversion performed by a digital-to-analog converter (digital-to-analog converter, DAC), where $f_0$ is a test frequency, fs is a sampling rate, and A is an amplitude of the excitation signal. In this application, * represents a multiplication sign.

Next, S(t) is input to a current generator, for example, a voltage-controlled current source (voltage-controlled current source, VCCS). The current generator generates an excitation current I(t) corresponding to S(t), and applies the excitation current I(t) to a battery. As shown in FIG. 1, I(t) is applied to a positive electrode of the battery. In addition, the excitation current I(t) may be alternatively applied to a negative electrode of the battery Herein, only an example in which the excitation current I(t) is applied to the positive electrode of the battery is used for description. For example, a VCCS circuit includes an operational amplifier and a power MOS transistor, as shown in FIG. 2. Therefore, I(t) is proportional to S(t). For example, $I(t)=\alpha*S(t)$, where $\alpha$ is a constant.

After I(t) is applied to the battery, a sampler detects a voltage V(t) at two ends of the battery, and performs analog-to-digital conversion to obtain V(n) corresponding to V(t). Because I(t) is a fixed periodic function, I(n) may be obtained by sampling a current of the battery online by the sampler, or may be stored as a constant after Fourier transform is performed on a current value obtained through pre-sampling, for example, $\sum_0^{N-1} I(n)*e^{-i2\pi kn/N}$. For example, the sampler may be an analog-to-digital converter (analog-to-digital converter, ADC).

Further, N-point fast Fourier transform (fast Fourier transform, FFT) is performed on V(n) to obtain $V(k)$, where $V(k)=\sum_0^{N-1} V(n)*e^{-i2\pi kn/N}$; and N-point FFT is performed on I(n) to obtain $I(k)$, where $I(k)=\sum_0^{N-1} I(n)*e^{-i2\pi kn/N}$. Finally, impedance $Z(\omega_0)$ of the battery at the test frequency $f_0$ is as follows:

$$Z(\omega_0)=\frac{V(k)}{I(k)}=\frac{\sum_0^{N-1} V(n)*e^{-i2\pi kn/N}}{\sum_0^{N-1} I(n)*e^{-i2\pi kn/N}}$$

N is a quantity of sampling points, $f_0$ is the test frequency, and fs is the sampling rate. Therefore, $f_0=\frac{fs*k}{N}$, and $\omega_0=\frac{2\pi*fs*k}{N}$, where k is a positive integer.

According to the foregoing method, sine wave excitation signals with test frequencies $f_0$, $f_1$, ..., and fm are successively applied to respectively determine obtained $Z(\omega_0)$, $Z(\omega_1)$, ..., and $Z(\omega_m)$, to form an EIS impedance spectrum, where m is a positive integer.

It should be noted that, in FIG. 1, an excitation signal is described by using a sine wave excitation signal as an example. In addition, the excitation signal may be a square wave signal, a triangular wave signal, or the like.

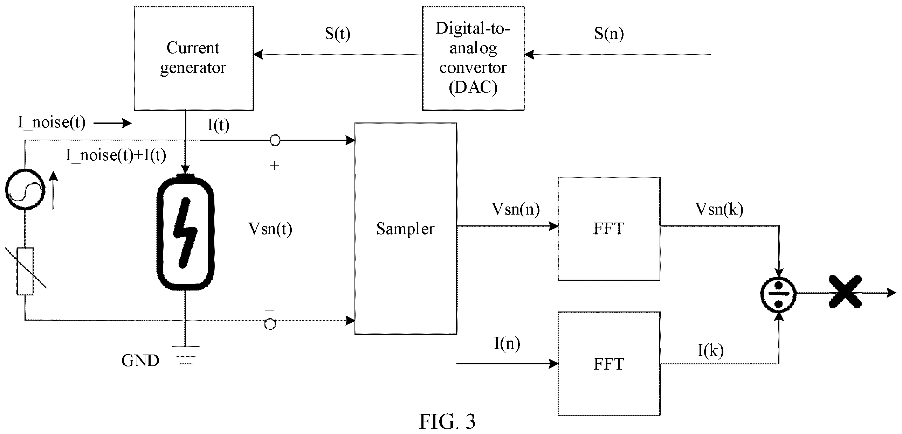

However, the foregoing EIS detection is a static detection method, and cannot implement EIS detection in a scenario in which load interference exists in a battery, in other words, cannot implement dynamic detection when a battery is in an online working state. That a battery is in an online working state may include: the battery is in a charging state or the battery is in a load discharging state. As shown in FIG. 3, when the battery works online, because an interference current I noise(t) is generated during charging or discharging, if the EIS detection is still performed, a voltage Vsn(t) at two ends of the battery is a voltage corresponding to an excitation response that includes both the current I(t) and the current I_noise(t), and an accurate result of impedance of the battery at the test frequency $f_0$ cannot be obtained. As a result, the EIS detection method fails.

Therefore, in a scenario in which EIS detection needs to be implemented when a battery is in a charging state or a load discharging state, the EIS detection method cannot meet a requirement. For example, to ensure battery safety, EIS detection may need to be performed on a battery in a new energy vehicle, a large quantity of batteries in a photovoltaic power station, and a battery included in a terminal device like a mobile phone, a watch, or a tablet computer when the battery works online. However, the EIS detection method cannot meet the foregoing requirement.

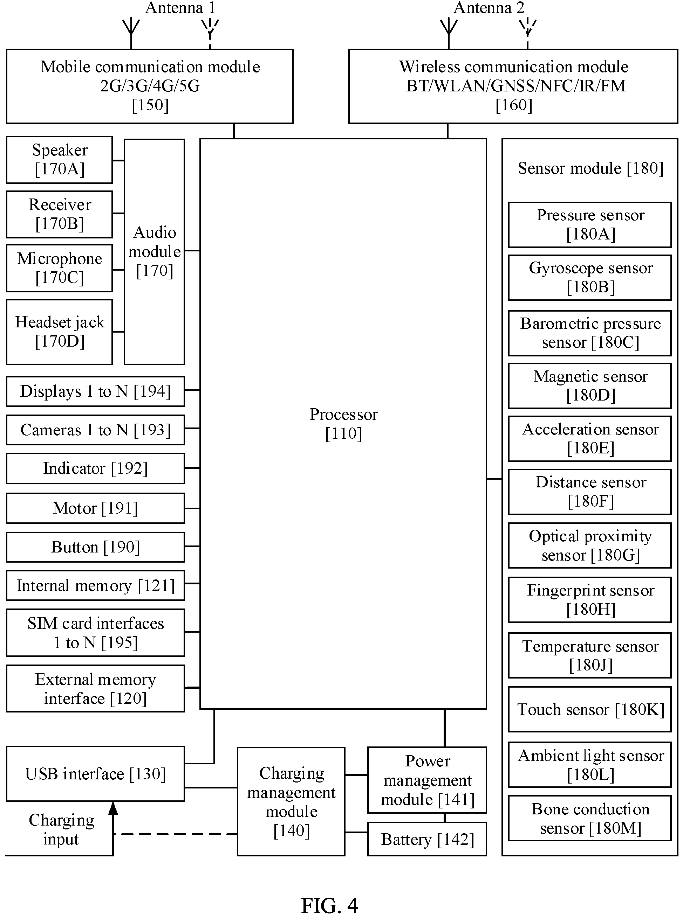

Embodiments of this application may be applied to various different terminal devices, such as a mobile phone, a personal computer (personal computer, PC), a tablet, a wearable device, a new energy vehicle, and a photovoltaic power station. The following uses a terminal device shown in FIG. 4 as an example to describe a specific application scenario of this embodiment of this application.

FIG. 4 is a schematic diagram of a structure of a terminal device. The terminal device may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display 194, a subscriber identification module (subscriber identification module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It may be understood that the structure shown in this embodiment of the present invention does not constitute a specific limitation on the terminal device. In some other embodiments of this application, the terminal device may include more or fewer components than those shown in the figure, or some components may be combined, or some components may be split, or a different component arrangement may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, and/or a neural-network processing unit (neural-network processing unit, NPU). Different processing units may be independent components, or may be integrated into one or more processors. The processor 110 may be located in one or more chips.

The controller may be a nerve center and a command center of the terminal device. The controller may generate an operation control signal based on an instruction operation code and a time sequence signal, to complete control of instruction reading and instruction execution.

A memory may be further disposed in the processor 110, and is configured to store instructions and data. In some embodiments, the memory in the processor 110 is a cache. The memory may store instructions or data that has been used or cyclically used by the processor 110. If the processor 110 needs to use the instructions or the data again, the processor may directly invoke the instructions or the data from the memory. This avoids repeated access, reduces waiting time of the processor 110, and improves system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/-transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The charging management module 140 is configured to receive charging input from a charger. The charger may be a wireless charger or a wired charger. In some embodiments of wired charging, the charging management module 140 may receive a charging input of a wired charger through the USB interface 130. In some embodiments of wireless charging, the charging management module 140 may receive a wireless charging input through a wireless charging coil of the terminal device. While charging the battery 142, the charging management module 140 may further supply power to the terminal device by using the power management module 141.

The power management module 141 is configured to connect to the battery 142, the charging management module 140, and the processor 110. The power management module 141 receives input of the battery 142 and/or the charging management module 140, to supply power to the processor 110, the internal memory 121, an external memory, the display 194, the camera 193, the wireless communication module 160, and the like. The power management module 141 may be further configured to monitor parameters such as a battery capacity, a battery cycle count, and a battery health status (electric leakage or impedance). In some other embodiments, the power management module 141 may alternatively be disposed in the processor 110. In some other embodiments, the power management module 141 and the charging management module 140 may alternatively be disposed in a same device.

The external memory interface 120 may be configured to connect to an external storage card, for example, a microSD card, to extend a storage capability of the terminal device. The external storage card communicates with the processor 110 through the external memory interface 120, to implement a data storage function. For example, a music file or a video file is stored in the external storage card.

The internal memory 121 maybe configured to store computer-executable program code. The executable program code includes instructions. The processor 110 runs the instructions stored in the internal memory 121, to perform various function applications and data processing of the terminal device. The internal memory 121 may include a program storage area and a data storage area. The program storage area may store an operating system, an application required by at least one function (for example, a sound playing function or an image playing function), and the like. The data storage area can store data (such as audio data and a phonebook) created during use of the terminal device, and the like. In addition, the internal memory 121 may include a high-speed random access memory, or may include a non-volatile memory, for example, at least one magnetic disk storage device, a flash memory, or a universal flash storage (universal flash storage, UFS).

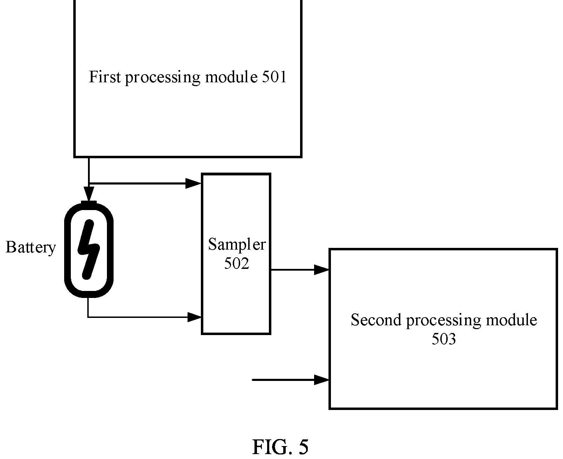

For example, the internal memory 121 is configured to store computer executable program code corresponding to this embodiment of this application, and the processor 110 is coupled to the internal memory 121. The computer executable program code stored in the internal memory 121 includes instructions. When the processor 110 executes the instructions, the terminal device is enabled to perform an impedance spectrum detection method for the battery 142 provided in an embodiment of this application. The method includes: performing first code transformation on a first signal based on a preset code, to obtain an excitation signal, and applying the excitation signal to a battery; after applying the excitation signal to the battery, sampling a voltage of the battery 142 by using a sampler, to obtain a sampled voltage signal; and performing second code transformation on the sampled voltage signal based on the preset code, to obtain a first voltage signal, performing the second code transformation on a current signal of the battery 142 based on the preset code, to obtain a first current signal, and determining, based on the first voltage signal and the first current signal, impedance corresponding to the battery 142. The following describes the foregoing method with reference to the apparatus shown in FIG. 5.

As shown in FIG. 5, this application provides a battery impedance spectrum detection apparatus, to implement EIS detection in a scenario in which load interference exists in a battery. The apparatus includes a first processing module 501, a sampler 502, and a second processing module 503. For example, the first processing module 501 and the second processing module 503 may be two function modules in the processor. Optionally, the first processing module 501 and the second processing module 503 may be integrated into a same module. Optionally, the first processing module 501 and the second processing module 503 may reuse some modules. The sampler 502 may be a hardware accelerator inside the processor 110, or may be an independent hardware component. Alternatively, the sampler 502 may be located inside the battery 142. This is not limited in embodiments. For example, the first processing module 501 and the second processing module 503 are two function modules in the processor 110 shown in FIG. 4, or the first processing module 501 and the second processing module 502 are respectively located in two processors 110. The first processing module 501 and the second processing module 503 may be implemented by hardware, software, or a combination thereof. This is not limited in this application. For example, the first processing module 501 and the second processing module 503 may be hardware acceleration logic calculation circuits in the processor 110. Alternatively, the first processing module 501 and the second processing module 503 may be software modules executed by the processor 110.

It may be understood that the impedance detection apparatus provided in this application may be used to measure impedance of the battery 142 at a test frequency corresponding to a first signal. Further, impedance of the battery 142 at a series of test frequencies may be obtained by changing the test frequency, to form an EIS impedance spectrum. It should be noted that this embodiment of this application may be applied to a scenario in which impedance of a battery is measured in a scenario in which load interference exists in the battery, for example, the battery is in a charging or load discharging state, and may also be applied to a scenario in which impedance of a battery is measured when the battery is in a static state. The detected impedance value or the detected EIS impedance spectrum is used by the processor 110 to manage the battery 142, to implement safety control on the battery 142.

With reference to FIG. 5, the first processing module 501 is configured to: perform first code transformation on a first signal based on a preset code, to obtain an excitation signal, and apply the excitation signal to the battery, where the first signal is an original signal used to generate the excitation signal; the sampler 502 is coupled to the battery, and is configured to sample a voltage of the battery after the excitation signal is applied to the battery, to obtain a sampled voltage signal; and the second processing module 503 is configured to: perform second code transformation on the sampled voltage signal based on the preset code, to obtain a first voltage signal; perform the second code transformation on a current signal of the battery based on the preset code, to obtain a first current signal; and determine, based on the first voltage signal and the first current signal, impedance corresponding to the battery. When the first processing module 501 and the second processing module 503 are implemented by using a hardware circuit, the first processing module 501 and the second processing module 503 may reuse some circuits, for example, reuse a circuit used for multiplication calculation. This is not limited in this embodiment. When the first processing module 501 and the second processing module 503 are implemented by using software, the first processing module 501 and the second processing module 503 may reuse some programs or functions, for example, reuse a program or a function used for multiplication calculation. This is not limited in this embodiment.

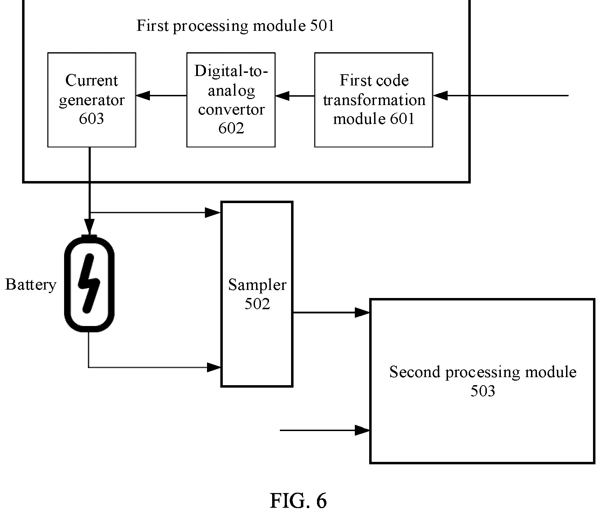

The following describes each component of the foregoing apparatus. FIG. 6 is a schematic diagram of each component included in the first processing module 501. It may be understood that the structure shown in FIG. 6 does not constitute a specific limitation on the first processing module 501. In some other embodiments of this application, the first processing module 501 may include more or fewer components than those shown in the figure, or may combine some components, or may split some components, or may have different component arrangements.

As shown in FIG. 6, the first processing module 501 includes a first code transformation module 601, a digital-to-analog converter 602, and a current generator 603. The first code transformation module 601 shown in the figure may be implemented by hardware, software, or a combination of software and hardware. The digital-to-analog converter 602 and the current generator 603 may be hardware.

The first code transformation module 601 is configured to multiply a preset code C(n) by a first signal, to obtain an excitation signal.

For example, as an original signal, the first signal may be a single-frequency signal or a multi-frequency signal, and is used to generate the excitation signal. For example, the first signal may be a sine wave signal, a square wave signal, a triangular wave signal, or the like. This is not limited in this application. The following uses only an example in which the first signal is a sine wave signal for description. For example, the first signal is: $s(n)=A*\sin(2\pi f_0 n/f_s)$, where $f_0$ is a test frequency, and fs is a sampling rate. Assuming that $f_0=125$ Hz and $f_s=32$ kHz, the first signal is: $s(n)=A*\sin(2\pi n/256)$.

For example, the preset code C(n) is a sequence including +1 and -1. For example, the preset code may be a periodic sequence including +1 and -1, or the preset code may be a non-periodic sequence including +1 and -1. For example, the preset code may be a random sequence including +1 and -1. It may be understood that the preset code in this application is different from a general binary code. In this application, a high electrical level is represented as 1, and a low electrical level is represented as -1, so that a sequence including +1 and -1 is formed. In addition, a product of the preset code and the preset code is an all-1 sequence.

For example, the preset code C(n) may be generated by a code generator. An output end of the code generator is separately connected to the first processing module 501 and the second processing module 503.

For example, the preset code C(n) is a periodic square wave sequence.

$$C(n)=\frac{4}{\pi}\left[\sin(\frac{2\pi*fc*n}{fs}) + \frac{1}{3}\sin(\frac{2\pi*3fc*n}{fs}) + \frac{1}{5}\sin(\frac{2\pi*5fc*n}{fs}) + \cdots\right] \qquad \text{Formula (1)}$$

Herein, $f_c=\frac{fs}{P}$ is a fundamental frequency, P is a periodicity length, and P is an integer multiple of $f_s/f_0$, that is, $P=m*f_s/f_0$, where m is a positive integer. For example, if m=8, $P=8\times32$ kHz$\div125$ Hz=2048. A length of C(n) is a quantity of sampling points in one sampling of the first signal, that is, a quantity N of sampling points. N=i*P, where i is a positive integer. For example, assuming that i=4, and P=2048, N=8192. For a manner of determining P and i, refer to related descriptions in the following.

When P=2048 and N=8192, C(n) may be expressed as:

$$C(n)=\begin{cases} 1 & j*2048 \le n < \left(j+\frac{1}{2}\right)*2048 & j=0,1,2,3 \\ -1 & \left(j+\frac{1}{2}\right)*2048 \le n < (j+1)*2048 & j=0,1,2,3 \end{cases}$$

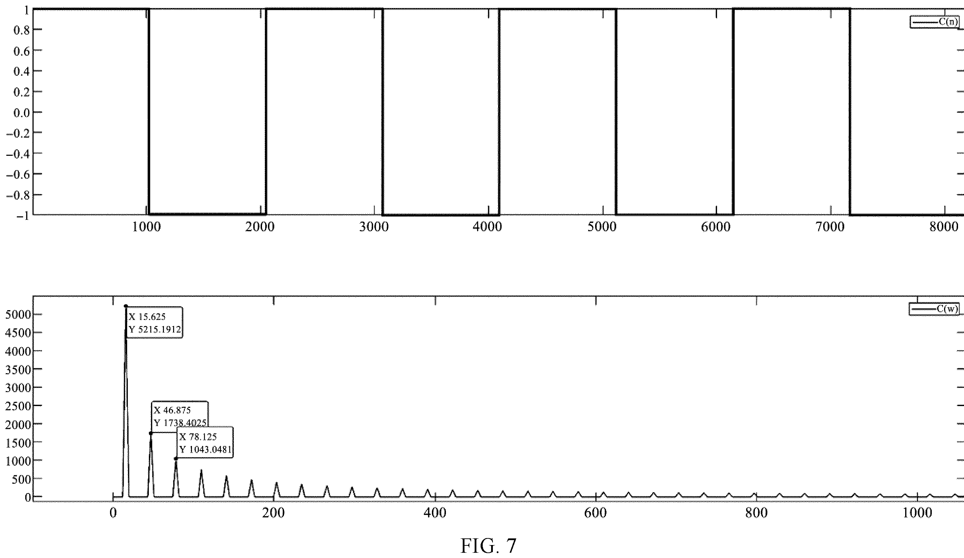

As shown in FIG. 7, an upper part in FIG. 7 is a time domain waveform C(n) of the preset code, and a lower part in FIG. 7 is a frequency domain waveform C($\omega$) of the preset code.

It may be understood that the first code transformation may also be referred to as wave code transformation. In addition to a multiplication manner, another manner may alternatively be used in the first code transformation to obtain the excitation signal Sc(n). This is not limited in this application. It should be noted that the excitation signal obtained in this case is a digital signal.

The digital-to-analog converter 602 is configured to perform digital-to-analog conversion on the excitation signal Sc(n), to obtain an analog signal Sc(t).

The current generator 603 is configured to: generate an excitation current Ic(t) based on the analog signal Sc(t), and apply the excitation current Ic(t) to a battery.

For example, the current generator 603 may be a VCCS or another module configured to generate a current. This is not limited in this embodiment.

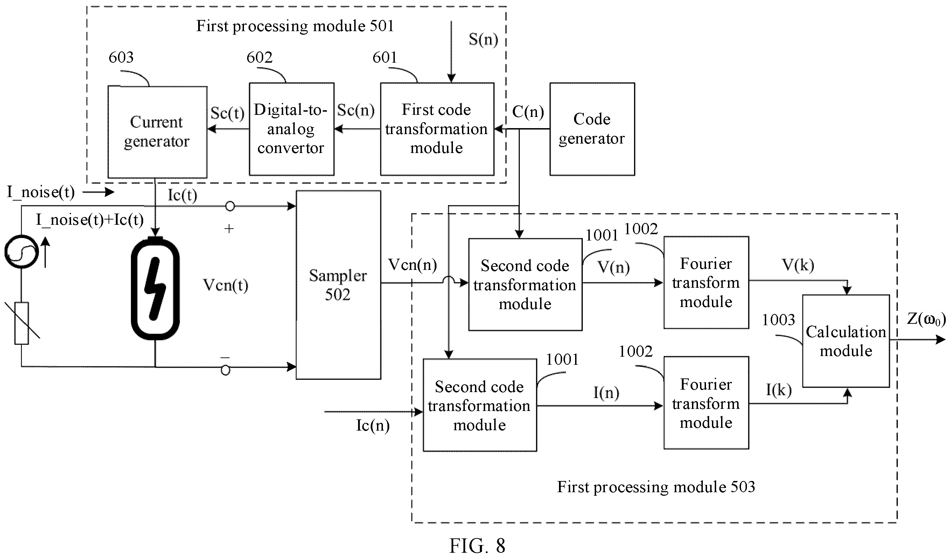

The following describes, with reference to FIG. 8, signals that pass through modules in the first processing module 501 when impedance of the battery is detected.

For example, the first signal is s(n)=A*sin($2\pi f_0 n/f_s$), and the preset code is Formula (1). The first code transformation module 601 multiplies s(n) by C(n), to obtain an excitation signal Sc(n). As shown in FIG. 8, the excitation signal output by the first code transformation module 601 is Sc(n), and Sc(n) is a digital signal.

$$Sc(n)=s(n)*C(n)$$

$$= A*\sin(\frac{2\pi*f_0*n}{f_s})*\frac{4}{\pi}[\sin(\frac{2\pi*f_c*n}{f_s})+\frac{1}{3}\sin(\frac{2\pi*3f_c*n}{f_s})+\frac{1}{5}\sin(\frac{2\pi*5f_c*n}{f_s})+\cdots]$$

$$=\frac{2A}{\pi}[\cos(\frac{2\pi*(f_0-f_c)*n}{f_s})-\cos(\frac{2\pi*(f_0+f_c)*n}{f_s})+\frac{1}{3}\cos(\frac{2\pi*(f_0-3f_c)*n}{f_s})-\frac{1}{3}\cos(\frac{2\pi*(f_0+3f_c)*n}{f_s})+\frac{1}{5}\cos(\frac{2\pi*(f_0-5f_c)*n}{f_s})-\frac{1}{5}\cos(\frac{2\pi*(f_0+5f_c)*n}{f_s})$$

$$+\cdots]$$

It is assumed that $f_0$=125 Hz, $f_s$=32 kHz, P=2048, and N=8192.

$$Sc(n)=\begin{cases}A*\sin\left(\frac{2\pi n}{256}\right) & j*2048\leq n<\left(j+\frac{1}{2}\right)*2048 & j=0,1,2,3\\-A*\sin\left(\frac{2\pi n}{256}\right) & \left(j+\frac{1}{2}\right)*2048\leq n<(j+1)*2048 & j=0,1,2,3\end{cases}$$ Formula (2)

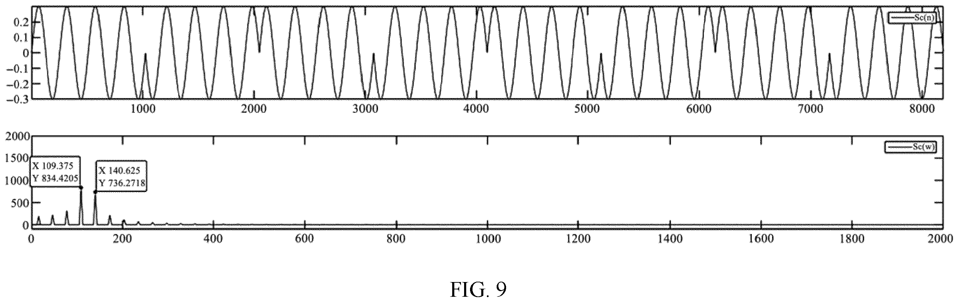

As shown in FIG. 9, an upper part in FIG. 9 is a time domain waveform Sc(n) of the excitation signal shown in Formula (2), and a lower part in FIG. 9 is a frequency domain waveform Sc(ω) of the excitation signal shown in Formula (2). It can be learned from Sc(n) that Sc(n) is no longer a complete sine wave waveform, and it can be learned from Sc(ω) that two harmonics (x=109.315, and x=140.625) of Sc(ω) are separately located on two sides of a fundamental frequency (x=125) (namely, the test frequency) of s(n).

Next, the digital-to-analog converter 602 performs digital-to-analog conversion on the excitation signal Sc(n) shown in Formula (2), to generate an analog signal Sc(t). As shown in FIG. 8, a signal output by the digital-to-analog converter 602 is Sc(t), and Sc(t) is an analog signal.

$$Sc(t)=\begin{cases}A*\sin\left(\frac{2\pi t}{256}\right) & j*2048\leq t<\left(j+\frac{1}{2}\right)*2048 & j=0,1,2,3\\-A*\sin\left(\frac{2\pi t}{256}\right) & \left(j+\frac{1}{2}\right)*2048\leq t<(j+1)*2048 & j=0,1,2,3\end{cases}$$ Formula (3)

It is assumed that the current generator 603 is a VCCS. As shown in FIG. 8, the current generator 603 generates an excitation current Ic(t) based on the analog signal Sc(t) shown in Formula (3), and applies the excitation current Ic(t), for example, a positive electrode of the battery, to the battery.

$$Ic(t)=\alpha*Sc(t)$$

$$=\begin{cases}\alpha A*\sin\left(\frac{2\pi t}{256}\right) & j*2048\leq t<\left(j+\frac{1}{2}\right)*2048 & j=0,1,2,3\\-\alpha A*\sin\left(\frac{2\pi t}{256}\right) & \left(j+\frac{1}{2}\right)*2048\leq t<(j+1)*2048 & j=0,1,2,3\end{cases}$$ Formula (4)

Herein, $\alpha$ is a constant coefficient.

The sampler 502 is configured to: after the excitation signal is applied to the battery, sample a voltage Vcn(t) at two ends of the battery, and perform analog-to-digital conversion on the collected voltage Vcn(t) of the battery, to obtain a sampled voltage signal Vcn(n). The sampled voltage signal Vcn(n) is a digital signal.

For example, as shown in FIG. 8, after the excitation signal Ic(t) is applied to the battery, the sampler 502 samples the voltage Vcn(t) of the battery, and performs analog-to-digital conversion on Vcn(t), to obtain the sampled voltage signal Vcn(n). The sampled voltage signal Vcn(n) is a digital signal corresponding to the voltage Vcn(t) of the battery.

In addition, the sampler 502 may be further configured to sample a current of the battery to obtain a current signal Ic(n). For example, as shown in FIG. 8, a current signal obtained by the sampler 502 by sampling the current of the battery is Ic(n).

Alternatively, in another implementation solution, the current signal Ic(n) may be determined through calculation based on the excitation signal. In addition, when the current signal Ic(n) is determined through calculation based on the excitation signal, an interference current is not considered for the current signal in this case. For example, the current of the battery is the excitation current Ic(t), and the current signal Ic(n) is a digital signal corresponding to Ic(t). Because Ic(t)=$\alpha$*Sc(t), Ic(n)=$\alpha$*Sc(n), where $\alpha$ is a constant.

It should be noted that the current signal Ic(n) obtained by using the sampler 502 or the current signal Ic(n) determined through calculation based on the excitation signal is a digital signal.

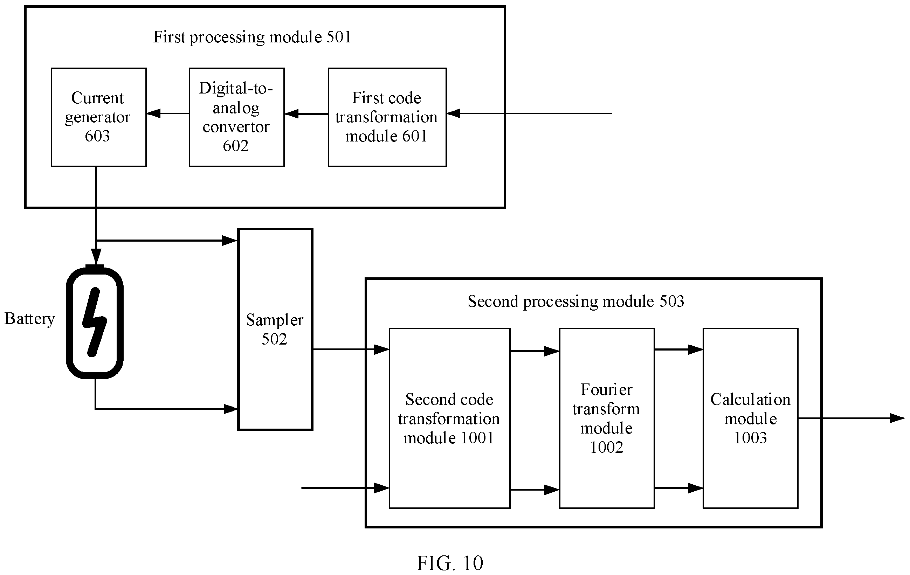

FIG. 10 is a schematic diagram of components included in the second processing module 503. It may be understood that the structure shown in FIG. 10 does not constitute a specific limitation on the second processing module 503. In some other embodiments of this application, the second processing module 503 may include more or fewer components than those shown in the figure, or some components may be combined, or some components may be split, or a different component arrangement may be used.

As shown in FIG. 10, the second processing module 503 includes a second code transformation module 1001, a Fourier transform module 1002, and a calculation module 1003. The components shown in the figure may be implemented by hardware, software, or a combination of software and hardware. For example, the second code transformation module 1001, the Fourier transform module 1002, and the calculation module 1003 may be hardware or software.

The second code transformation module 1001 is configured to: multiply the preset code C(n) by the sampled voltage signal Vcn(n) to obtain a first voltage signal V(n), and multiply the preset code C(n) by the current signal Ic(n) to obtain a first current signal I(n).

It may be understood that the second code transformation may also be referred to as inverse wave code transformation. In addition to a multiplication manner, another manner may alternatively be used in the second code transformation. This is not limited in this application.

The Fourier transform module 1002 is configured to: perform Fourier transform on the first voltage signal V(n) to obtain a voltage Fourier transform result V(k), and perform Fourier transform on the first current signal I(n) to obtain a current Fourier transform result I(k).

The calculation module 1003 is configured to determine, based on the voltage Fourier transform result V(k) and the current Fourier transform result I(k), the impedance corresponding to the battery.

The following describes, with reference to FIG. 8, signals that pass through modules in the second processing module 503 when the impedance of the battery is detected.

The second code transformation module 1001 multiplies the sampled voltage signal Vcn(n) obtained by the sampler 502 by the preset code C(n) corresponding to Formula (1), to obtain a first voltage signal Vn(n), and multiplies the current signal Ic(n) by the preset code C(n) corresponding to Formula (1), to obtain a first current signal I(n). As shown in FIG. 8, the second code transformation module 1001 outputs the first voltage signal Vn(n) and the first current signal I(n).

In the following, Vcn(n)=$\mu$*(Ic(n)+I_noise(n)) is used as an example. I_noise(n) is a digital signal corresponding to an interference current I_noise(t), and $\mu$ is a constant related to the impedance of the battery. Assuming that a frequency of the interference current I_noise(t) falls on the test frequency $f_0$, that is, I_noise(t)=B*cos($2\pi nf_0 t$), I_noise(n) =B*cos($2\pi nf_0 n$). It should be understood that the interference current I_noise(t) is caused by a load when the battery has a load, for example, in a charging circuit or in a load discharging circuit. The following deduction is performed.

$$Vn(n)=\overline{Vcn(n)} * \overline{c(n)}$$

$$=\mu*(Ic(n)+I\_noise(n)) * C(n)$$

$$=\mu*(\alpha*Sc(n)+I\_noise(n)) * C(n)$$

$$=\frac{2A\alpha\mu}{\pi}[\beta * \cos(\frac{2\pi*f_0*n}{f_s}) + \cos(\frac{2\pi*(f_0-f_c)*n}{f_s})-\cos(\frac{2\pi*(f_0+f_c)*n}{f_s})+$$

$$\frac{1}{3}\cos(\frac{2\pi*(f_0-3f_c)*n}{f_s})-\frac{1}{3}\cos(\frac{2\pi*(f_0+3f_c)*n}{f_s})+\frac{1}{5}\cos(\frac{2\pi*(f_0-5f_c)*n}{f_s})-\frac{1}{5}\cos(\frac{2\pi*(f_0+5f_c)*n}{f_s}) + \cdots]*\frac{4}{\pi}[\sin(\frac{2\pi*f_c*n}{f_s}) + \frac{1}{3}\sin(\frac{2\pi*3f_c*n}{f_s}) +$$

$$\frac{1}{5}\sin(\frac{2\pi*5f_c*n}{f_s}) + \cdots]$$

$$=\frac{8A\alpha\mu}{\pi^2}(1 + \frac{1}{9} + \frac{1}{25} + \cdots)\sin(\frac{2\pi*f0*n}{fs}) +... \quad\quad \text{Formula (5)}$$

Herein, $\beta=\frac{B\pi}{2A\alpha}$.

$$I(n)=Ic(n)*C(n)=\alpha*Sc(n)*C(n)=\alpha*S(n)*C(n)*C(n)=\alpha*S(n) \quad\quad \text{Formula (6)}$$

Herein, C(n)*C(n)=1.

Assuming that $f_0$=125 Hz, $f_s$=32 kHz, P=2048, and N=8192 are substituted into Formula (5) and Formula (6), the following is obtained.

$$Vn(n)=\frac{8A\alpha\mu}{\pi^2}(1+\frac{1}{9}+\frac{1}{25}+\cdots)\sin(\frac{2\pi*n}{256})+...$$  Formula (7)

$$I(n)=\alpha*A*\sin(2\,\alpha)$$  Formula (8)

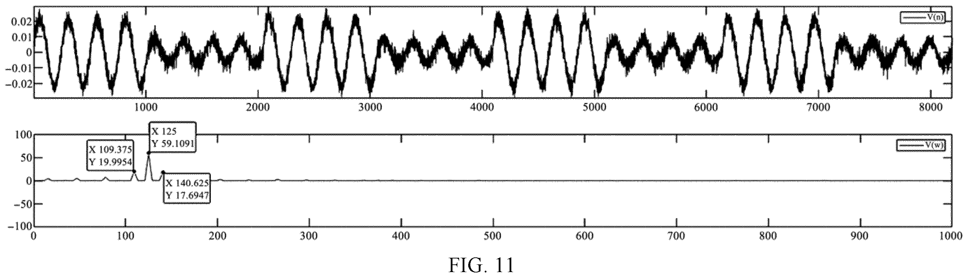

As shown in FIG. 11, an upper part in FIG. 11 is a time domain waveform Vn(n) of the first voltage signal shown in Formula (7), and a lower part in FIG. 11 is a frequency domain waveform Vn($\omega$) of the first voltage signal shown in Formula (7). Therefore, an amplitude corresponding to the test frequency $f_0$ is irrelevant to I noise(n). A fundamental frequency of Vn(<n) is the same as the test frequency $f_0$.

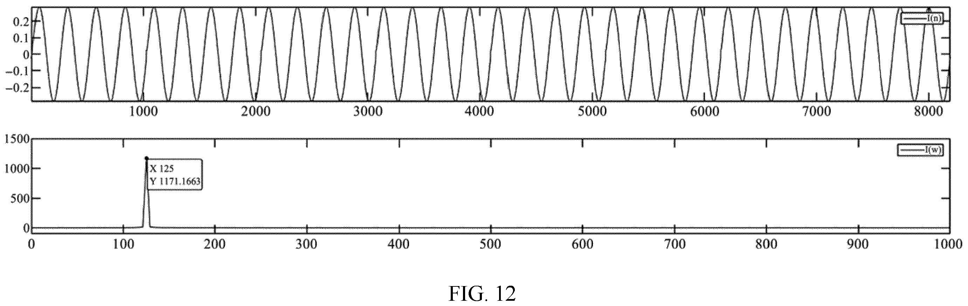

As shown in FIG. 12, an upper part in FIG. 12 is a time domain waveform I(n) of the first current signal shown in Formula (8), and a lower part in FIG. 12 is a frequency domain waveform I($\omega$) of the first current signal shown in Formula (8). A fundamental frequency of I($\omega$) is the same as the test frequency $f_0$.

The Fourier transform module 1002 performs Fourier transform on the first voltage signal Vn(n) and the first current signal I(n) separately to obtain a voltage Fourier transform result $V(k)$ and a current Fourier transform result $I(k)$. As shown in FIG. 8, the Fourier transform module 1002 outputs the voltage Fourier transform result $V(k)$ and the current Fourier transform result $I(k)$.

For example, N-point FFT is performed on Vn(n) to obtain V(k), where $V(k)=\sum_0^{N-1}Vn(n)*e^{-i2\pi kn/N}$ , and N-point FFT is performed on I(n) to obtain $I(k)$, where $I(k)=\sum_0^{N-1}I(n)*e^{-i2\pi kn/N}$ .

The calculation module 1003 is configured to determine, based on the voltage Fourier transform result $V(k)$ and the current Fourier transform result $I(k)$, impedance Z($\omega_0$) corresponding to the battery.

For example, the impedance Z($\omega_0$) of the battery at the test frequency $f_0$ is as follows:

$$Z(\omega_0)=\frac{V(k)}{I(k)}=\frac{\sum_0^{N-1}Vn(n)*e^{-i2\pi kn/N}}{\sum_0^{N-1}I(n)*e^{-i2\pi kn/N}}$$

Assuming that fo=125 Hz, N=8192, and fs=32 kHz, the following is obtained.

$$Z(250\pi)=\frac{V(32)}{I(32)}=\frac{\sum_0^{N-1}Vn(n)*e^{-i2\pi n*32/8192}}{\sum_0^{N-1}I(n)*e^{-i2\pi n*32/8192}}$$

It should be noted that the foregoing process may also be referred to as a detection phase, and the detection phase is used to detect the impedance of the battery. The following describes a manner of determining a periodicity of the preset code. The manner of determining the periodicity of the preset code may also be referred to as an observation phase. The observation phase is used to detect a frequency of the interference current, to determine the periodicity of the preset code, and the preset code is used as input of the detection phase. In addition, when the preset code is a non-periodic sequence, a process of determining the periodicity of the preset code may not be performed, that is, the following process does not need to be performed.

The following describes a manner of determining the periodicity of the preset code. The following solution is performed when the excitation signal is not applied to the battery, to determine how to determine a proper periodicity of the preset code when load interference exists, so as to perform subsequent excitation signal application and measurement.

The sampler 502 is further configured to: before the first processing module 501 applies the excitation signal to the battery, that is, when the excitation signal is not applied to the battery, sample a voltage of the battery, to obtain an interference voltage signal.

For example, when the excitation signal is not applied to the battery, the sampler 502 samples the voltage of the battery, to obtain an interference voltage signal V'n(t).

The second processing module 503 is further configured to determine the periodicity of the preset code based on the sampled interference voltage signal.

For example, the Fourier transform module 1002 is configured to perform Fourier transform on the interference voltage signal to obtain a Fourier transform result corresponding to the interference voltage signal, where the Fourier transform result corresponding to the interference voltage signal includes N frequency domain values, and N is a quantity of sampling points.

The calculation module 1003 is further configured to: when $|V(2\pi f+\frac{2\pi*(i-1)}{N}*f_s)|>\delta$ and $|V(2\pi f-$

$\frac{2\pi*(i-1)}{N} * f_s)| > \delta$ , and $|V(2\pi f + \frac{2\pi*i}{N} * f_s)| < \delta$ and $|V(2\pi f - \frac{2\pi*i}{N} * f_s)| < \delta$ , determine that a periodicity length P of the preset code is equal to N/i, where $V(2\pi f + \frac{2\pi*(i-1)}{N} * f_s), V(2\pi f - \frac{2\pi*(i-1)}{N} * f_s), V(2\pi f + \frac{2\pi*i}{N} * f_s)$ and $V(2\pi f - \frac{2\pi*i}{N} * f_s)$ belong to the N frequency domain values, f is the test frequency, $\delta$ is a preset threshold, and i is a positive integer.

For example, the Fourier transform module 802 performs N-point FFT on V'n(t) to obtain the N frequency domain values, and a specific result is as follows: $\{V(0), V(\frac{2\pi*1}{N} * f_s), V(\frac{2\pi*2}{N} * f_s), ..., V(\omega_0 - \frac{2\pi*3}{N} * f_s)$ ,

$V(\omega_0 - \frac{2\pi*2}{N} * f_s), V(\omega_0 - \frac{2\pi*1}{N} * f_s), V(\omega_0), V(\omega_0 + \frac{2\pi*1}{N} * f_s), V(\omega_0 + \frac{2\pi*2}{N} * f_s), V(\omega_0 + \frac{2\pi*3}{N} * f_s), ...\}$ , and compares signal strength of V'n(t) with the preset threshold $\delta$ according to the following sequence:

(a) determine whether $|V(\omega_0)| < \delta$, and if $|V(\omega_0)| < \delta$, fc=0Hz, and $\omega c = 2\pi$ * fc=0; otherwise, perform (b);

(b) determine whether $|V(\omega_0 + \frac{2\pi*1}{N} * f_s)| < \delta$ and $|V(\omega_0 - \frac{2\pi*1}{N} * f_s)| < \delta$ , and if $|V(\omega_0 + \frac{2\pi*1}{N} * f_s)| < \delta$ and $|V(\omega_0 - \frac{2\pi*1}{N} * f_s)| < \delta$ , i=1, $fc = \frac{fs}{N}$ , and $\omega c = \frac{2\pi*f_s}{N}$ ; otherwise, perform (c);

(c) determine whether $|V(\omega 0 + \frac{2\pi*2}{N} * f_s)| < \delta$ and $|V(\omega_0 - \frac{2\pi*2}{N} * f_s)| < \delta$ , and if $|V(\omega 0 + \frac{2\pi*2}{N} * f_s)| < \delta$ and $|V(\omega_0 - \frac{2\pi*2}{N} * f_s)| < \delta$ , i=2, $fc = \frac{2*fs}{N}$, $\omega c = \frac{2\pi*2fs}{N}$ ; otherwise, perform (d); and ...

According to the foregoing process, it is determined that the periodicity length of the preset code is P, where $P = \frac{N}{i}$ , P=m *$f_s/f_0$, and m is a positive integer. Therefore, even if the interference current causes strong co-channel interference, high impedance detection precision can still be obtained.

For example, assuming that $f_0$=125 Hz, fs=32 kHz, N=8192, and it is determined that $|V(250\pi + \frac{2\pi*3}{8192}*32000)| > \delta$ and $|V(250\pi - \frac{2\pi*3}{8192} * 32000)| > \delta$ , but $|V(250\pi + \frac{2\pi*4}{8192}*32000)| < \delta$ and $|V(250\pi - \frac{2\pi*4}{8192} * 32000)| < \delta$ , it is determined that i=4, and a periodicity length P of the preset code C(n) whose length is 8192 is equal to 2048.

The EIS detection solution provided in embodiments of this application has features of strong anti-interference and high precision. A reason is that first code transformation is first performed on a first signal based on a preset code to obtain an excitation signal, the excitation signal is applied to a battery, and then second code transformation is separately performed on a sampled voltage signal and a current signal of the battery based on the preset code, so that a fundamental frequency of a first voltage signal is the same as a fundamental frequency (namely, a test frequency) of the first signal, and a fundamental frequency of a first current signal is the same as the fundamental frequency (namely, the test frequency) of the first signal. However, for an interference current and a corresponding voltage signal, only the second code transformation is performed (the first code transformation is not performed), and a spectrum of the interference current is spread to other frequencies in a large quantity. Therefore, the interference signal spectrum is eliminated on the test frequency of EIS detection.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

According to a fifth aspect, this application further provides an apparatus. The apparatus may be a chip or a circuit that can execute the foregoing solution, and includes a corresponding function, for example, includes a processor, for example, the processor 110 in FIG. 4.

A person skilled in the art may clearly understand that, for the purpose of convenient and brief description, for a specific working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units. Some or all of the units may be selected based on actual requirements to achieve the objectives of the solutions of embodiments.

In addition, function units in embodiments of this application may be integrated into one processing unit, each of the units may exist alone physically, or two or more units are integrated into one unit.

When the functions are implemented in the form of a software function unit and sold or used as an independent product, the functions may be stored in a computer-readable storage medium, for example, the internal memory 121 shown in FIG. 4. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory ROM, a random access memory RAM, a magnetic disk, or an optical disc.

**Claims**

1.  A battery impedance detection apparatus, wherein the apparatus comprises:

    a first processing module, configured to: perform first code transformation on a first signal based on a preset code, to obtain an excitation signal, and apply the excitation signal to a battery, wherein the first signal is an original signal used to generate the excitation signal;
    a sampler, coupled to the battery, and configured to sample a voltage of the battery after the excitation signal is applied to the battery, to obtain a sampled voltage signal; and
    a second processing module, configured to: perform second code transformation on the sampled voltage signal based on the preset code, to obtain a first voltage signal; perform the second code transformation on a current signal of the battery based on the preset code, to obtain a first current signal; and determine, based on the first voltage signal and the first current signal, impedance corresponding to the battery.

2.  The apparatus according to claim 1, wherein the first processing module comprises a first code transformation module, configured to multiply the preset code by the first signal, to obtain the excitation signal.

3.  The apparatus according to claim 1 or 2, wherein the first processing module comprises:

    a digital-to-analog converter DAC, configured to perform digital-to-analog conversion on the excitation signal to obtain an analog signal; and
    a current generator, configured to: generate an excitation current based on the analog signal, and apply the excitation current to the battery.

4.  The apparatus according to any one of claims 1 to 3, wherein the sampler is further configured to sample a current of the battery, to obtain the current signal; or
    the current signal is determined through calculation based on the excitation signal.

5.  The apparatus according to any one of claims 1 to 4, wherein the second processing module comprises:
    a second code transformation module, configured to: multiply the preset code by the sampled voltage signal, to obtain the first voltage signal, and multiply the preset code by the current signal, to obtain the first current signal.

6.  The apparatus according to any one of claims 1 to 5, wherein a product of the preset code and the preset code is an all-1 sequence.

7.  The apparatus according to claim 6, wherein the preset code is a sequence that comprises +1 and -1.

8. The apparatus according to any one of claims 1 to 7, wherein the preset code is a periodic sequence, and the sampler is further configured to: before the first processing module applies the excitation signal to the battery, sample the voltage of the battery, to obtain an interference voltage signal; and

   the second processing module is further configured to determine a periodicity of the preset code based on the sampled interference voltage signal.

9. A battery impedance detection apparatus, wherein the apparatus comprises:

   a processor, configured to: perform first code transformation on a first signal based on a preset code, to obtain an excitation signal, and apply the excitation signal to a battery, wherein the first signal is an original signal used to generate the excitation signal; and

   a sampler, coupled to the battery, and configured to sample a voltage of the battery after the excitation signal is applied to the battery, to obtain a sampled voltage signal, wherein

   the processor is further configured to: perform second code transformation on the sampled voltage signal based on the preset code, to obtain a first voltage signal; perform the second code transformation on a current signal of the battery based on the preset code, to obtain a first current signal; and determine, based on the first voltage signal and the first current signal, impedance corresponding to the battery.

10. The apparatus according to claim 9, wherein the processor is configured to: when performing the first code transformation on the first signal based on the preset code, to obtain the excitation signal, multiply the preset code by the first signal, to obtain the excitation signal.

11. The apparatus according to claim 9 or 10, wherein the processor is configured to: when applying the excitation signal to the battery, perform digital-to-analog conversion on the excitation signal, to obtain an analog signal, generate an excitation current based on the analog signal, and apply the excitation current to the battery.

12. The apparatus according to any one of claims 9 to 11, wherein the sampler is further configured to sample a current of the battery, to obtain the current signal; or

    the current signal is determined through calculation based on the excitation signal.

13. The apparatus according to any one of claims 9 to 12, wherein the processor is further configured to: when performing the second code transformation on the sampled voltage signal based on the preset code, to obtain the first voltage signal, and performing the second code transformation on the current signal of the battery based on the preset code, to obtain the first current signal, multiply the preset code by the sampled voltage signal, to obtain the first voltage signal, and multiply the preset code by the current signal, to obtain the first current signal.

14. The apparatus according to any one of claims 9 to 13, wherein a product of the preset code and the preset code is an all-1 sequence.

15. The apparatus according to claim 14, wherein the preset code is a sequence that comprises +1 and -1.

16. The apparatus according to any one of claims 9 to 15, wherein the preset code is a periodic sequence, and the sampler is further configured to: before the first processing module applies the excitation signal to the battery, sample the voltage of the battery, to obtain an interference voltage signal; and

    the processor is further configured to determine a periodicity of the preset code based on the sampled interference voltage signal.

FIG. 1

FIG. 2

FIG. 3

FIG. 4

First processing module 501

Battery

Sampler
502

Second processing module
503

FIG. 5

First processing module 501

| Current generator 603 | ← | Digital-to-analog convertor 602 | ← | First code transformation module 601 | ← |

Battery

Sampler 502

Second processing module 503

FIG. 6

FIG. 7

FIG. 8

FIG. 9

EP 4 462 137 A1

First processing module 501

| Current generator 603 | ← | Digital-to-analog convertor 602 | ← | First code transformation module 601 | ← |

Battery

Sampler 502

Second processing module 503

| Second code transformation module 1001 | → | Fourier transform module 1002 | → | Calculation module 1003 | → |

FIG. 10

FIG. 11

FIG. 12

EP 4 462 137 A1

# INTERNATIONAL SEARCH REPORT

| International application No. |
| --- |
| **PCT/CN2022/079623** |

| A. | CLASSIFICATION OF SUBJECT MATTER |
| --- | --- |

G01R 31/36(2019.01)i; H02J 7/00(2006.01)i

According to International Patent Classification (IPC) or to both national classification and IPC

| B. | FIELDS SEARCHED |
| --- | --- |

Minimum documentation searched (classification system followed by classification symbols)

G01R H02J

Documentation searched other than minimum documentation to the extent that such documents are included in the fields searched

Electronic data base consulted during the international search (name of data base and, where practicable, search terms used)

CNKI, CNABS, CNTXT, VEN, EPTXT, USTXT, WOTXT, IEEE: 电化学阻抗谱, 二进制, 序列, 周期性, electrochemical impedance spectroscopy, EIS, binary sequence, battery, FFT

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | 王筱彤 (WANG, Xiaotong). "燃料电池EIS测试系统设计及故障诊断方法研究 (Non-official translation: Research on EIS Measurement Design and Fault Diagnosis Method of Fuel Cell)" 中国优秀硕士学位论文全文数据库 (工程科技I辑) (China Master's Theses Full-text Database (Engineering Science & Technology I)), No. 7, 15 July 2021 (2021-07-15), ISSN: 1674-0246, sections 3.3-3.5 | 1-16 |
| X | 王筱彤 (WANG, Xiaotong). "基于离散区间二进制序列激励信号的燃料电池EIS测量及故障诊断方法 (EIS Measurement Based on DIBS Excitation Signal and Fault Diagnosis Method of Fuel Cell)" 中国电机工程学报 (Proceedings of the CSEE), Vol. 40, No. 14, 20 July 2020 (2020-07-20), ISSN: 0258-8013, pages 4526-4537 | 1-16 |
| A | CN 109451772 A (GBATTERIES ENERGY CANADA INC.) 08 March 2019 (2019-03-08) entire document | 1-16 |

| ☑ Further documents are listed in the continuation of Box C. | ☑ See patent family annex. |
| --- | --- |

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **16 November 2022** | **30 November 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2022/079623**

**C.    DOCUMENTS CONSIDERED TO BE RELEVANT**

| Category* | Citation of document, with indication, where appropriate, of the relevant passages | Relevant to claim No. |
|---|---|---|
| A | 李伟恒 等 (LI, Weiheng et al.). "基于伪随机二进制序列的阻抗谱快速重构及其在电化学能源领域的应用 (Recent Advancement in Pseudo-Random Binary Sequence Signals-Based Fast Reconstruction of Impedance Spectrum and Its Applications in Electrochemical Energy Sources)" 电化学 (*Journal of Electrochemistry*), Vol. 26, No. (03), 28 June 2020 (2020-06-28), ISSN: 1006-3471, pages 370-388 | 1-16 |
| A | 周苏 等 (ZHOU, Su et al.). "燃料电池交流阻抗谱在线测量算法研究 (Research on An Algorithm of Situ Electrochemical Impedance Spectroscopies Measurement of Fuel Cellst)" 机电一体化 (*Mechatronics*), No. 10, 07 January 2016 (2016-01-07), ISSN: 1007-080X, pages 27-33 | 1-16 |
| A | G. Petrone et al. "EIS Method for the On-Board Evaluation of the Fuel Cell Impedance" *2018 IEEE 4th International Forum on Research and Technology for Society and Industry (RTSI)*, 29 November 2018 (2018-11-29), pages 1-6 | 1-16 |

Form PCT/ISA/210 (second sheet) (January 2015)

INTERNATIONAL SEARCH REPORT
Information on patent family members

International application No.

**PCT/CN2022/079623**

| Patent document cited in search report | | | Publication date (day/month/year) | Patent family member(s) | | | Publication date (day/month/year) |
|---|---|---|---|---|---|---|---|
| CN | 109451772 | A | 08 March 2019 | EP | 3433918 | A1 | 30 January 2019 |
| | | | | CN | 114498858 | A | 13 May 2022 |
| | | | | EP | 3799250 | A1 | 31 March 2021 |

Form PCT/ISA/210 (patent family annex) (January 2015)